# EUROPÄISCHE PATENTSCHRIFT

(11) **EP 0 976 166 B1**
(45) Veröffentlichungstag und Bekanntmachung des Hinweises auf die Patenterteilung: **19.12.2007**
(21) Anmeldenummer: 98930643.6
(22) Anmeldetag: 08.04.1998
(51) Int. Cl.: H01L 41/083, H01L 41/053

(54) **PIEZOELEKTRISCHER AKTOR MIT EINEM HOHLPROFIL**
PIEZOELECTRIC ACTUATOR WITH A HOLLOW PROFILE
ACTIONNEUR PIEZOELECTRIQUE COMPORTANT UN PROFILE CREUX

(30) Priorität: 14.04.1997 DE 19715487
(43) Veröffentlichungstag der Anmeldung: 02.02.2000
(73) Patentinhaber: Siemens VDO Automotive AG, 93055 Regensburg (DE)
(72) Erfinder: FITZNER, Johannes, D-93170 Bernhardswald (DE); RINK, Jürgen, D-92442 Wackersdorf (DE); KIRCHWEGER, Karl, D-93057 Regensburg (DE); LEWENTZ, Günter, D-93055 Regensburg (DE); YALCIN, Hakan, D-93059 Regensburg (DE); SCHUH, Carsten, D-85598 Baldham (DE); HEKELE, Wilhelm, D-83125 Eggstätt (DE)
(86) Internationale Anmeldenummer: PCT/DE1998/001021
(87) Internationale Veröffentlichungsnummer: WO 1998/047188

(56) Entgegenhaltungen:
- EP-A- 0 319 038
- EP-A- 0 414 138
- PATENT ABSTRACTS OF JAPAN vol. 013, no. 078 (E-718), 22. Februar 1989 & JP 63 260087 A (OLYMPUS OPTICAL CO LTD), 27. Oktober 1988

## Beschreibung

Die Erfindung betrifft einen piezoelektrischen Aktor gemäß dem Oberbegriff des Patentanspruchs 1.

Piezoelektrische Aktoren werden beispielsweise in der Kraftfahrzeugtechnik zur Ansteuerung von Einspritzventilen verwendet.

Aus der JP-A-63260087 ist ein piezoelektrischer Aktor bekannt, der in einem Gehäuse eingebracht ist. Zwischen dem piezoelektrischen Aktor und dem Gehäuse ist ein elastisches, isolierendes Material eingebracht.

Aus EP-A-0 319 038 ist ein Gehäuse bekannt, in das ein piezoelektrischer Aktor eingebracht ist. Als elektrische Anschlüsse sind Drähte vorgesehen, die frei im Gehäuse geführt sind. Zudem ist eine isolierende Flüssigkeit im Gehäuse vorgesehen.

Die Aufgabe der Erfindung beruht darin, einen kostengünstigen und einfach zu fertigenden piezoelektrischen Aktor bereit zu stellen.

Die Aufgabe der Erfindung wird durch die Merkmale des Anspruchs 1 gelöst. Ein wesentlicher Vorteil der Erfindung beruht darin, daß der Aktor kostengünstig hergestellt wird, indem der Aktor in ein vorgefertigtes Hohlprofil eingebettet wird. Dadurch entfällt ein Entformungsprozess, der bei einer Umspritzung des piezoelektrischen Aktors notwendig ist.

Weitere vorteilhafte Ausbildungen und Verbesserungen der Erfindung sind in den abhängigen Ansprüchen angegeben.

Im folgenden wird die Erfindung anhand der Figuren näher erläutert; es zeigen:
Figur 1 einen piezoelektrischen Aktor,
Figur 2 ein Hohlprofil
Figur 3 ein Hohlprofil mit einem piezoelektrischen Aktor,
Figur 4 einen passivierten piezoelektrischen Aktor,
Figur 5 einen piezoelektrischen Aktor mit einem angespritzten Steckergehäuse und
Figur 6 einen piezoelektrischen Aktor mit einem aufgeschobenen Kontaktstecker.

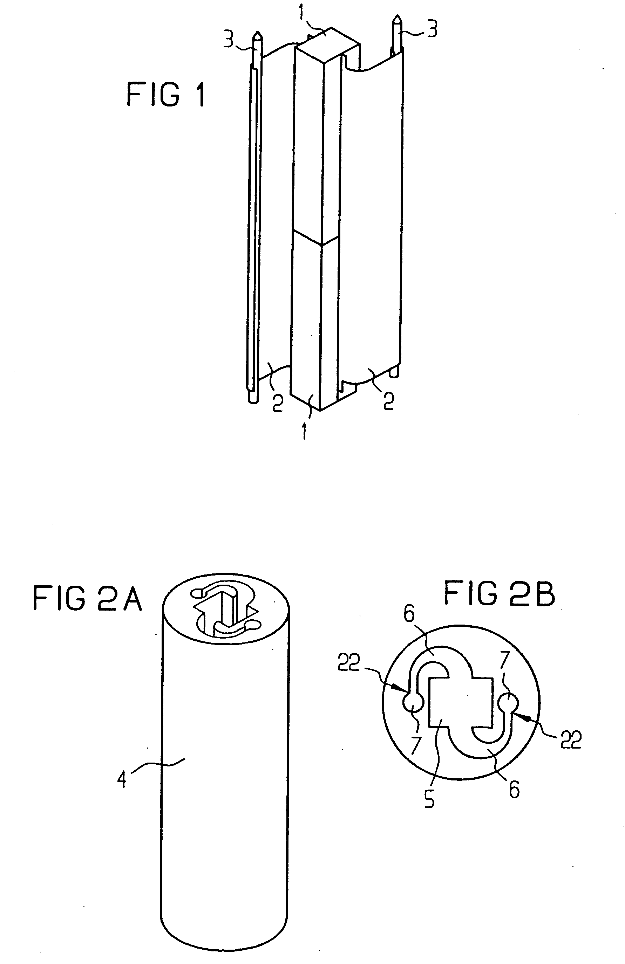

Figur 1 zeigt einen piezoelektrischen Aktor 1, der aus zwei Stapeln alternierender Elektroden- und Keramikschichten 1 besteht. Die Elektrodenschichten sind mit zwei seitlich an jedem Stapel angebrachten, streifenförmigen Metallisierungen versehen, die jeweils mit einer elektrisch leitenden Kontaktfahne 2 verbunden sind. Jede Kontaktfahne 2 ist an einem Kontaktstift 3 angeschlossen, die parallel zur Längsrichtung der zwei Stapel 1 angeordnet sind und den oberen Stapel 1 in Längsrichtung überragen.

Figur 2 zeigt ein Hohlprofil 4, das eine zylindrische Außenform aufweist, die beispielsweise nach dem Stranggußverfahren, dem Spritzgußverfahren oder nach dem Extrudierverfahren als Kunststoffhülse hergestellt wurde.

Die Kontaktstifte 3 sind als starre Stifte ausgebildet und mittels Widerstands-, Laserschweißen oder Laserlöten mit der Kontaktfahne 2 verbunden. Das Hohlprofil 4 ist geringfügig kürzer als der Aktor 1 mit den zwei Stapeln.

Figur 2b zeigt schematisch die innere Kontur des Hohlprofils, die eine zentrale, im wesentlichen rechteckige Ausnehmung 5 aufweist, von der an zwei gegenüberliegenden Seiten zwei Schlitze 6 ausgehen, die jeweils in eine Stiftausnehmung 7 münden. Die Schlitze 6 sind vorzugsweise in einem vorgegebenen Radius gekrümmt ausgebildet, wobei der obere Schlitz 6 in Richtung auf die linke Seitenfläche der zentralen Ausnehmung 5 und der untere Schlitz 6 in Richtung auf die rechte Seitenfläche der Ausnehmung 5 geführt ist. Die Schlitze 6 verjüngen sich ausgehend von der zentralen Ausnehmung 5 in Richtung auf die Stiftausnehmung 7. Die leicht gekrümmte Ausführung der Schlitze 6 ermöglicht ein einfaches Einführen der Kontaktfahnen 2 und der Kontaktstifte 3 in das Hohlprofil 4. Anstelle der in Figur 2 dargestellten Kontur des Hohlprofils sind auch andere Hohlprofile möglich, wobei im einfachsten Fall eine einzige zentrale Ausnehmung zur Aufnahme des Piezoaktors mit seinen elektrischen Anschlüssen 2, 3 ausreicht.

Die Schlitze 6 weisen im Übergangsbereich 22 zu den Stiftausnehmungen 7 einen kleineren Durchmesser auf als der Durchmesser der Kontaktstifte 3 ist. Auf diese Weise wird verhindert, daß die Kontaktstifte 3 aus der Stiftausnehmung 7 herausrutschen. Dadurch werden die Kontaktstifte 3 in ihrer Position genau festgelegt und sind somit für einen automatisierten Fertigungsprozess gut geeignet. Das in Figur 2 dargestellte Hohlprofil hat weiterhin den Vorteil, daß es einfach und kostengünstig zu fertigen ist.

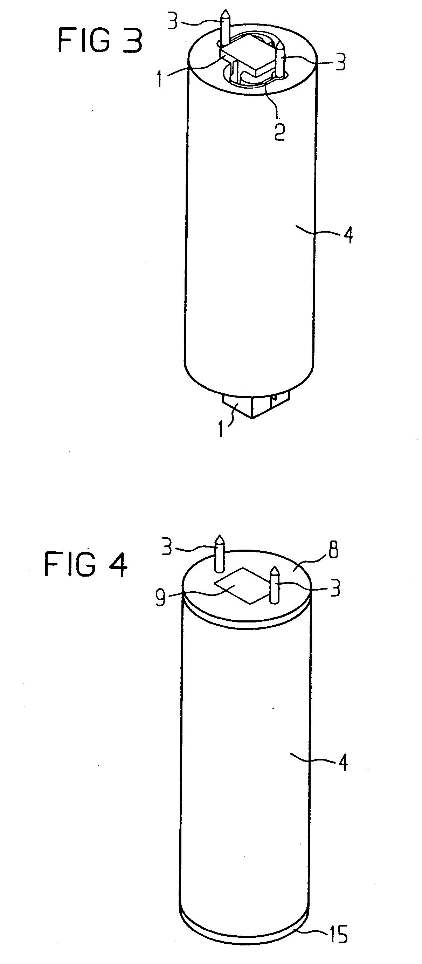

Figur 3 zeigt einen piezoelektrischen Aktor 1 mit Kontaktstiften 3 und Kontaktfahnen 2, der in das Hohlprofil 4 eingefügt ist. Der Aktor 1 befindet sich in der zentralen Ausnehmung 5, von der aus die Kontaktfahnen 2 über die Schlitze 6 zu den Stiftausnehmungen 7 geführt sind, in denen sich die Kontaktstifte 3 befinden. Vorzugsweise ragt der Aktor 1 über das obere und das untere Ende des Hohlprofils 4 heraus. Ebenso sind die Kontaktstifte 3 über das obere Ende des Hohlprofils 4 und über das obere Ende des Stapels 1 geführt. Die Kontaktstifte 3 sind in ihrer Position zueinander und zum Hohlprofil 4 genau festgelegt. Durch die leicht gekrümmte Ausführung der Schlitze 6 ist trotz der langen Kontaktfahnen 2 eine relativ kompakte Bauweise des Aktors 1 möglich.

Figur 4 zeigt einen Piezoaktor mit einem Hohlprofil 4 entsprechend Figur 3, bei dem der verbleibende Raum zwischen dem Aktor 1 und den Ausnehmungen 5,6,7 des Hohlprofils 4 mit einer Passivierungsschicht mindestens teilweise ausgefüllt ist, damit der Aktor 1 fest mit dem Hohlprofil 4 verbunden ist.

Die Passivierungsschicht im Innern des Hohlprofils 4 wird beispielsweise aus spritzfähigem Silikon hergestellt.

Zudem ist der über den oberen Rand des Hohlprofils 4 und über den unteren Rand des Hohlprofils 4 hinausragende Teil des Aktor 1 von einer elastischen Passivierung 8,15 mindestens seitlich umgossen, die beispielsweise aus streichfähigem Silikon, das nach der Verarbeitung aushärtet, hergestellt wird.

Die Oberseite der oberen Passivierungsschicht 8 und die Unterseite der unteren Passivierungsschicht 15 schließen mit dem oberen Ende und dem unteren Ende des oberen beziehungsweise des unteren Stapels 1 ab. Auf diese Weise wird gewährleistet, daß der Aktor 1 an einem Gehäuse 13 oder an einem Stellglied direkt anliegt.

Vorzugsweise ist auch die Oberseite und die Unterseite des Aktors mit einer Passivierungsschicht vorgegebener Dicke abgeweckt, die als Dämpfungs- und Schutzpolster dient. Die Kontaktstifte 3 ragen über die obere Passivierungsschicht 8 hinaus.

Der in Figur 4 dargestellte piezoelektrische Aktor ist leicht zu handhaben, einfach zu Kontaktieren und für die weitere Verarbeitung durch das umgebende, dichte Hohlprofil 4 und die Passivierungsschicht 8, 15 geschützt.

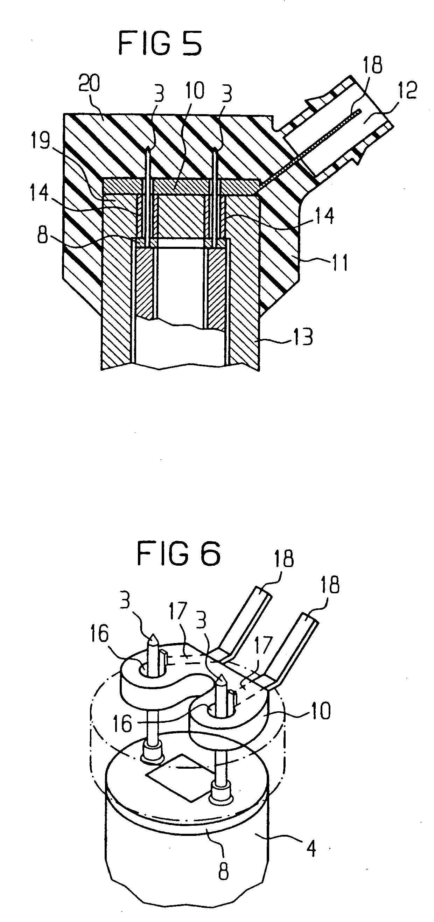

Eine bevorzugte weitere Bearbeitung des piezoelektrischen Aktors besteht darin, auf die Kontaktstifte 3 eine Kontaktplatte 10 aufzustecken, die in einem entsprechenden Abstand zwei durchgehende Kontaktlöcher 16 aufweist, in die die Kontaktstifte 3 eingesteckt werden, wie in Figur 6 dargestellt ist. Die Kontaktplatte 10 ist vorzugsweise aus einem isolierenden Kunststoff gebildet, wobei im Inneren der Kontaktplatte 10 ausgehend von den Kontaktlöchern 16 jeweils eine elektrische Leitung 17 zu einem Anschlußstift 18 geführt ist, die aus der Kontaktplatte 10 herausragen.

Für eine weitere Verarbeitung wird der piezoelektrische Aktor mit dem Hohlprofil 4 in ein Gehäuse 13 eingeschoben, wobei das Gehäuse 13 in einer Deckplatte 19 elektrisch isolierte Durchführungen 14 zum Durchführen der Kontaktstifte 3 aufweist, wie in Figur 5 dargestellt ist. Das Gehäuse 13 ist beispielsweise aus Metall, insbesondere Stahl oder Aluminium oder aus einer Keramik gefertigt. Die Durchführungen 14 sind bei einem elektrisch leitenden Gehäuse 13 isoliert ausgebildet.

Auf die Kontaktstifte 3 wird, wie in Figur 6 dargestellt, die Kontaktplatte 10 aufgesteckt. Anschließend werden der obere Teil des Gehäuses 13, die Kontaktstifte 3 und die Kontaktplatte 10 mit einem Steckergehäuse 20 umspritzt. Das Steckergehäuse 20 ist derart ausgebildet, daß die Anschlußstifte 18 in eine Anschlußkammer 12 ragen und somit für eine Kontaktierung bereit stehen.

Figur 5 zeigt somit eine Baueinheit mit einem piezoelektrischen Aktor 1, mit Gehäuse 13 und mit einem Steckergehäuse 20, die fertig vormontiert ist und mit der Anschlußkammer 12 auf einem entsprechenden Injektor aufgeflanscht werden kann.

## Patentansprüche

1. Piezoelektrischer Aktor (1) mit elektrischen Anschlüssen (3) zum Steuern der Länge des Aktors (1),
wobei der Aktor (1) in ein vorgefertigtes Hohlprofil (4) eingebracht ist,
wobei das Hohlprofil (4) mit einer Passivierungsschicht wenigstens teilweise ausgegossen ist, und
wobei die elektrischen Anschlüsse (3) aus der Passivirungsschicht und dem Hohlprofil (4) herausgeführt sind, **dadurch gekennzeichnet,**
- **daß** als elektrische Anschlüsse Kontaktfahnen (2) vorgesehen sind,
- **daß** das Hohlprofil (4) eine zentrale Ausnehmung (5) und zwei von der zentralen Ausnehmung (5) ausgehende Schlitze (6) aufweist,
- **daß** der Aktor (1) in der zentralen Ausnehmung angeordnet ist und die Kontaktfahnen (2) in den Schlitzen (6) geführt sind.

2. Piezoelektrischer Aktor nach Anspruch 1, **dadurch gekennzeichnet, daß** mindestens die Oberseite des Aktors (1) über das Hohlprofil (4) hinausragt, und daß der aus dem Hohlprofil (4) herausragende Teil des Aktors (1) mindestens seitlich mit einer Passivierungsschicht (8) umgossen ist.

3. Piezoelektrischer Aktor nach Anspruch 1, **dadurch gekennzeichnet, daß** die Stifte nahezu parallel zur Längsrichtung des Aktors (1) angeordnet sind, und daß die Stifte in Längsrichtung über den Aktor (1) auf einer Seite hinausragen.

4. Piezoelektrischer Aktor nach Anspruch 3, **dadurch gekennzeichnet, daß** das Hohlprofil (5) zwei seitlich zur zentralen Ausnehmung (5) versetzte Stiftausnehmungen (7) aufweist, die über Schlitze (6) mit der zentralen Ausnehmung (5) verbunden sind.

5. Piezoelektrischer Aktor nach Anspruch 4, **dadurch gekennzeichnet, daß** die Schlitze (6) im Übergang zu den Stiftausnehmungen (7) eine kleinere Breite aufweisen als die Stifte (3), damit die Stifte (3) in den Stiftausnehmungen (7) festgehalten werden und somit einen definierten Abstand zueinander aufweisen.

6. Piezoelektrischer Aktor nach Anspruch 1, **dadurch gekennzeichnet, daß** das Hohlprofil (4) mindestens teilweise in ein Gehäuse (13) eingebracht ist, daß die Stifte (3) durch das Gehäuse (13) in ein an das Gehäuse (13) angespritztes Stekkergehäuse (11) geführt sind, daß die Stifte (3) mit einer Kontaktplatte (10) mit Steckerfahnen (18) angeschlossen sind, die in eine Anschlußkammer (12) ragen.

7. Piezoelektrischer Aktor nach einem der Ansprüche 4 bis 6, **dadurch gekennzeichnet, daß** die Stifte (3) über Folien (2) an den Aktor (1) angeschlossen sind, und daß die Schlitze (6) senkrecht zur Längsrichtung des Aktors (1) gesehen in eine= gekrümmten Bahn ausgebildet sind, in der die Folien (2) geführt sind.

## Claims

1. Piezoelectric actuator (1) with electrical terminals (3) for controlling the length of the actuator (1),
with the actuator (1) being introduced into a prefabricated hollow section (4),
with the hollow section (4) being at least partially sealed with a passivating layer and
with the electrical terminals (3) being led out from the passivating layer and the hollow section (4), **characterised in that**
- contact lugs (2) are provided as electrical terminals
- the hollow section (4) comprises a central recess (5) and two slots (6) emanating from the central recess (5),
- the actuator (1) is arranged in the central recess and the contact lugs (2) are guided in the slots (6).

2. Piezoelectric actuator according to claim 1, **characterised in that** at least the upper side of the actuator (1) protrudes above the hollow section (4) and that the part of the actuator (1) protruding from the hollow section (4) is sealed at least laterally with a passivating layer (8).

3. Piezoelectric actuator according to claim 1, **characterised in that** the pins are arranged almost in parallel with the longitudinal direction of the actuator (1) and that on one side the pins protrude above the actuator (1) in the longitudinal direction.

4. Piezoelectric actuator according to claim 3, **characterised in that** the hollow section (5) comprises two pin recesses (7) which are laterally offset from the central recess (5), said pin recesses (7) being connected to the central recess (5) by way of slots (6).

5. Piezoelectric actuator according to claim 4, **characterised in that** the slots (6) at their transition from the pin recesses (7) have a narrower width than the pins (3), so that the pins (3) are retained in the pin recesses (7) and thus are at a defined distance from one another.

6. Piezoelectric actuator according to claim 1, **characterised in that** the hollow section (4) is at least partially introduced into a housing (13), that the pins (3) are guided through the housing (13) into a connector housing (11) moulded onto the housing (13), that the pins (3) are connected to a contact plate (10) with connector lugs (18), which protrude into a connecting chamber (12).

7. Piezoelectric actuator according to one of claims 4 to 6, **characterised in that** the pins (3) are connected to the actuator (1) via films (2) and that the slots (6) are embodied in a curved path, viewed at right angles from the longitudinal direction of the actuator (1), in which curved path the films (2) are guided.

## Revendications

1. Actionneur piézoélectrique (1) équipé de connexions électriques (3) servant à déterminer la longueur de l'actionneur (1),
dans lequel l'actionneur (1) est logé dans un profilé creux préfabriqué (4),
le profilé creux (4) étant rempli au moins partiellement d'une couche de passivation et
les connexions électriques (3) étant prolongées hors de la couche de passivation et du profilé creux (4), **caractérisé**
- **en ce que**, comme connexions électriques, sont prévues des lamelles de contact (2),
- **en ce que** le profilé creux présente un évidement central (5) et deux fentes (6) qui partent de l'évidement central (5),
- **en ce que** l'actionneur (1) est disposé dans l'évidement central et les lamelles de contact (2) s'étendent dans les fentes (6).

2. Actionneur piézoélectrique selon la revendication 1, **caractérisé en ce qu'**au moins le côté supérieur de l'actionneur (1) s'étend au-delà du profilé creux (4) et **en ce que** la partie de l'actionneur (1) qui fait saillie hors du profilé creux (4) est entourée par coulée, au moins latéralement, avec une couche de passivation (8).

3. Actionneur piézoélectrique selon la revendication 1, **caractérisé en ce que** les broches sont disposées à peu près parallèlement à la direction longitudinale de l'actionneur (1) et **en ce que**, sur un côté, les broches se prolongent au-delà de l'actionneur (1) dans la direction longitudinale.

4. Actionneur piézoélectrique selon la revendication 3, **caractérisé en ce que** le profilé creux (5) présente deux évidements de broche (7) décalés latéralement par rapport à l'évidement central (5) et, qui sont reliés à l'évidement central (5) par des fentes (6).

5. Actionneur piézoélectrique selon la revendication 4, **caractérisé en ce qu'**à la transition avec les évidements de broche (7), les fentes (6) présentent une plus petite largeur que les broches (3) afin qu'elles soient immobilisées dans les évidements de broche (7) et qu'elles présentent ainsi un écartement mutuel défini.

6. Actionneur piézoélectrique selon la revendication 1, **caractérisé en ce que** le profilé creux (4) est emboîté au moins partiellement dans un boîtier (13), **en ce que** les broches (3) s'étendent à travers le boîtier (13) en s'engageant dans un boîtier de fiche (11) moulé par injection sur le boîtier (13), et **en ce que** les broches (3) munies d'une plaque de contact (10) sont connectées à des lamelles de fiche (18) qui font saillie dans une chambre de connexion (12).

7. Actionneur piézoélectrique selon une des revendications 4 à 6, **caractérisé en ce que** les broches (3) sont connectées à l'actionneur (1) par l'intermédiaire de lamelles (2) et **en ce que** les fentes (6) sont formées selon un trajet courbe, vu perpendiculairement à la direction longitudinale de l'actionneur (1), dans lequel les lamelles s'étendent.
